Europäisches Patentamt

European Patent Office

Office européen des brevets

(11) Publication number: **0 276 518**
**A1**

## EUROPEAN PATENT APPLICATION

(21) Application number: **87202642.2**

(51) Int. Cl.4: **C23C 18/46**

(22) Date of filing: **29.12.87**

(30) Priority: **07.01.87 NL 8700017**

(43) Date of publication of application:
**03.08.88 Bulletin 88/31**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Molenaar, Arian**
**c/o INT. OCTROOIBUREAU B.V. Prof.**
**Holstlaan 6**
**NL-5656 AA Eindhoven(NL)**
Inventor: **Daenen, Theo Ernest Gerard**
**c/o INT. OCTROOIBUREAU B.V. Prof.**
**Holstlaan 6**
**NL-5656 AA Eindhoven(NL)**
Inventor: **Van der Laan, Klaas Christiaan**
**c/o INT. OCTROOIBUREAU B.V. Prof.**
**Holstlaan 6**
**NL-5656 AA Eindhoven(NL)**
Inventor: **Dreise, Gerrit Roelf**
**c/o INT. OCTROOIBUREAU B.V. Prof.**
**Holstlaan 6**
**NL-5656 AA Eindhoven(NL)**

(74) Representative: **Auwerda, Cornelis Petrus et**
**al**
**INTERNATIONAAL OCTROOIBUREAU B.V.**
**Prof. Holstlaan 6**
**NL-5656 AA Eindhoven(NL)**

(54) **Lead immersion bath and method of supplificially exchanging a tin layer for a lead layer.**

(57) A lead immersion bath and method of superficially exchanging a tin layer for a lead layer, and a lead-tin alloy layer, respectively, which bath comprises an alkaline solution of a lead (II) compound and a complexing agent, in which the complexing agent has been chosen so that the complex constant of the lead complex in the solution used is smaller than the dissociation constant of hydroxyplumbite ions. The lead-tin alloy layer is obtained by a thermal treatment between 183°C and 232°C.

## Lead immersion bath and method of superficially exchanging a tin layer for a lead layer.

The invention relates to a lead immersion bath for superficially exchanging a tin layer for a lead layer, which bath comprises an alkaline solution of a lead (II) compound and a complexing agent with which lead ions can form a soluble lead complex.

The invention also relates to a method of superficially exchanging a tin layer for a lead layer while using such a lead exchanging bath.

The invention moreover relates to a printed circuit board having metallized holes and comprising a top layer of a lead-tin alloy obtained while using such a method.

A lead immersion bath is disclosed in United States Patent Specification 2,230,602. The bath described in the said Specification comprises an aqueous solution of a lead (II) compound, an alkali metal hydroxide and an alkali metal cyanide. By immersing articles having a given surface of metal, including tin, in the said bath, the metal is exchanged at the surface for a lead layer.

It is known that copper layers, whether or not provided in the form of a pattern on printed circuit boards, cannot be soldered or can be soldered only poorly soon after providing the said copper layers. The solderability is improved by providing a tin layer on the copper, for example, by means of an electroless tin-plating bath, as described in European Patent Application EP 180265. These thin tin layers may give rise to the formation of whiskers. Whiskers are very thin, needle-like (single) crystals which grow from the tin surface. When used in, for example, electronic circuits, this may produce disturbances. Thin tin layers provided via other methods may also give rise to the formation of whiskers. An article by J.L. Jostan in Galvanotechnik 71, 946-955 (1980) describes how the formation of whiskers is suppressed if the tin layer comprises at least 1% of lead. It is known from Japanese Patent Application (Kokai) JP 5931 886 (Chem.Abstracts 101 , 119403C, 1984) that the formation of whiskers in tin layers is suppressed when a thin lead layer is provided on the tin layer.

An important property of the tin layers is their solderability. In general, this is considerably improved by providing the lead layer.

Such a thin lead layer may be provided by means of a lead exchanging bath as described in the already mentioned United States Patent Specification US 2,230,602.

A disadvantage of such a bath is the presence of a high concentration of dissolved cyanide compounds, which are very poisonous. This requires special measures in regenerating and draining such baths.

It is the object of the invention to provide a lead immersion bath for tin in which the formation of whiskers is suppressed, the formed layer can be excellently soldered, and in which the cyanide is replaced by a less poisonous substance.

This object is achieved by means of a lead immersion bath as described in the opening paragraph, which bath is characterized according to the invention in that the complexing agent has been chosen so that the complex constant of the lead complex is smaller than the dissociation constant of hydroxyplumbite ions.

In the experiments which have resulted in the invention it has been found that a bath which comprises an aqueous alkaline lead salt solution and in which an article is dipped the surface of which has a tin layer, yields a spongy non-adhering lead layer on the tin surface. The formed lead layer is spongy due to too high a lead deposition rate in these circumstances.

When dissolving a lead (II) compound in an alkaline medium, hydroxyplumbite ions are formed according to the reaction equation:

$$Pb^{2+} + 3OH^- \rightarrow HFbO_2^- + H_2O$$

The dissociation constant $K_d$ of hydroxyplumbite ions is defined as:

$$K_d = [Pb^{2+}] [OH^-]^3 [HPbO_2^-]^{-1}.$$ At room temperature this is approximately equal to $10^{-15}$.

Reducing the deposition rate of the lead is based on the recognition of the fact that this can be achieved by reducing the activity of the $Pb^{2+}$-ions. This can be achieved by adding to the solution a substance which binds the $Pb^{2+}$ ions more strongly than that they are bound in the hydroxyplumbite ions, or in other words, if this substance is a complexing agent for lead (II) ions in which the complexing constant $K_c$ is smaller than the dissociation constant $K_d$ of hydroxyplumbite ions.

In these circumstances a complexing agent for lead should be found the complex constant $K_c$ of which is smaller than $10^{-15}$. The complex constant $K_c$ is defined as :

$$K_c = [Pb^{2+}] [C] [PbC]^{-1}$$

in which C is the complexing agent.

According to the invention this object is achieved by chosing a complexing agent from the group formed by ethylenediamine tetracetic acid (EDTA), ethylenediamine tetramethyl phosphonic acid (EDTMP), diethylene triamine pentacetic acid (DETPA), and alkali metal salts of these acids. The complex constant $K_c$ of the lead-EDTA complex is approximately $10^{-18}$, that of lead-DETPA complex is approximately $10^{-19}$, and that of the lead-EDTMP complex is approximately $10^{-18}$.

The complex constant $K_c$ of the lead (II) cyanide complex is approximately $10^{-10}$.

A preferred embodiment of the lead exchanging bath comprises from 0.001 to 0.1 mol/l of lead (II) acetate, as well as alkali metal hydroxide and as a complexing agent ethylene diamine tetracetic acid tetra sodium salt.

Another embodiment of the lead immersion bath comprises from 0.001 to 0.1 mol/l of tin (II) chloride. Microscopic examination has demonstrated that the interstices between the lead crystals in the lead layer formed in such a bath are filled with tin and lead. This effect may also occur in lead layers which are formed in lead immersion baths in which a quantity of tin has already been exchanged for lead. From this it follows that when a more constant composition of the formed layer is desired, tin (II) chloride may be added to the lead immersion bath.

Another object of the invention is to provide a method of superficially exchanging a tin layer for a lead layer.

According to the invention this object is achieved by means of a method according to which a lead immersion bath is used which comprises a complexing agent having a complex constant of the lead complex which is smaller than the dissociation constant of hydroxyplumbite ions, which method according to the invention is further characterized in that the exchanged layer is subjected to a thermal treatment between 183°C and 232°C while forming a top layer of a lead-tin alloy.

The limit of the said thermal treatment is determined by the eutectic temperature of lead-tin (183°C) and the melting-point of tin (232°C). As a result of this thermal treatment, the lead layer on the tin is converted into a top layer of a lead-tin alloy, as a result of which the solderability is improved. A preferred treatment is carried out at 215°C for 45 seconds. It will be obvious that other periods may be determined by those skilled in the art, if the treatment temperature and/or the rate of the heat transfer is changed. In a vapour phase soldering set-up, for example, the thermal energy is transferred by condensing vapour of high-molecular fluorocarbons (for example, fluorinet FC(70) of Messrs. 3M). The use of fluxes also stimulates the heat transfer.

The invention also provides printed circuit panels having metallized holes and comprising a top layer of a lead-tin alloy.

The invention will be described in greater detail with reference to the following specific examples:

### EXAMPLE 1

A copper plate, dimensions 30 x 10 x 3 mm, comprising a tin layer which has been provided by electroless plating, is cleaned in a sodium hydroxide solution at 85°C, rinsed in water, and then dipped in 300 ml of an aqueous solution of the following composition for 5 minutes:
0.02 mol/l of lead (II) acetate
0.46 mol/l of sodium hydroxide
0.10 mol/l of ethylene diamine tetracetic acid tetrasodium salt.

The temperature of the solution is 25°C. The solution is stirred by means of a magnetic stirrer at a rate of 600 rpm. The thickness of the lead layer produced is approximately 0.9 $\mu$m. The plate is rinsed in demineralised water and dried. Before the solderability is measured, an accelerated ageing procedure is carried out in which the plate is subjected to a thermal treatment of 155°C for 16 hours. The solderability is measured by means of a so-called wetting balance ("Multicore Solders") as described inter alia in Circuit World 10, No 3, pp. 4-7, 1984. The forces occurring when a sample is introduced into a soldering bath are measured as a function of time by the recording apparatus coupled to the said balance. The plate is dipped upright in a liquid solder bath using a slightly activated flux. In the first instance an upward force is exerted on the plates which decreases to zero when the surface layer of the solders has flattened along the plate. The time required for this is indicated by $t_i$. The wetting then produces a downward force. The fraction of this force which is measured after 3 seconds with respect to an ideally wetted plate is indicated by $F_3/F_{max}$.

This measuring method is described in the standard sheet 68-2-54 of IEC. The value of $t_i$ must in practice be smaller than 1 sec. and $F_3/F_{max}$ must be larger than 50%.

The following result has been measured:
$t_i$ = 0.84 sec. $F_3/F_{max}$ = 70%.

### Example 2

A copper plate, dimensions 30 x 10 x 3 mm, comprising a tin layer which has been provided by electroless tin-plating is stored in air for a few days. After cleaning for 3 minutes in a 1 M sodium hydroxide solution at 85°C and rinsing in water, the said plate is dipped for 1 minute in an aqueous solution of the following composition:
0.01 mol/l of lead (II) acetate,
1.18 mol/l of sodium hydroxide,
0.1 mol/l of ethylene diamine tetracetic acid tetra sodium salt, and
0.05 mol/l of tin (II) chloride.

The temperature of the solution is 60°C.
The thickness of the lead layer formed is 0.36 $\mu$m.

Microscopic examination has demonstrated that the interstices between the lead crystallites are filled with tin and lead, so that the formed layer is smoother than the original tin layer.

Example 3

A panel of 40 x 65 mm comprising a metal pattern and 50 metallized holes having a diameter of 1.0 mm and 50 metallized holes having a diameter of 0.7 mm (on an area of 24 x 24 mm) is dipped in an electroless tin-plating bath in which the metal patterns and the walls of the holes are tin-plated. The said panel is then cleaned for 3 minutes in a sodium hydroxide solution at 85°C and, after rinsing in water, is dipped for 5 minutes in the lead immersion solution of example 1.

After this, the lead layer on the tin is converted into a lead-tin alloy by means of a thermal treatment. The thermal treatment is carried out in a hot-air furnace at a temperature of 215°C. The panels are placed in the furnace and are left there for 135 seconds. Prior to the solderability test the panels are subjected to an accelerated ageing procedure in which the panels are placed in steam for 2.5 hours and are then dried at 105°C for 16 hours. The solderability is then tested as in example 4.

The result of the solderability measurement is that 90% of the large holes are filled entirely and 10% hereof are three-quarters filled. 86% Of the small holes are filled entirely and 14% are three quarters filled.

If no thermal treatment is used, all holes are found to be less than three quarters filled.

Example 4

A panel as in example 3 is dipped in an electroless tin-plating bath in which the metal patterns and the walls of the holes are tin-plated. The said panel is then cleaned for fifteen minutes in a sodium hydroxide solution at 85°C and, after rinsing, is dipped in a lead immersion bath of example 1 at a temperature at 30°C.

The lead layer on the tin is then converted into a lead-tin alloy by a thermal treatment. The thermal treatment is carried out in a vapour phase soldering set-up, in which the thermal energy is transferred by a fluorinet FC (70) compound (of Messrs. 3M) at a temperature of 215°C for 45 seconds. As is usual in vapour phase soldering, the panel is previously dipped in a slightly activated flux and dried at 75°C for 15 minutes.

Prior to the solderability test, the panels are subjected to an accelerating ageing procedure in which the panels are placed in steam for 5 hours and are then dried at 105°C for 16 hours. The panel is then tested for solderability according to the so-called rotary-dip method. This method is described in standard sheet 68-2-20 of IEC. In this method one side of the panel is contacted horizontally for 3 seconds with a molten lead-tin bath and is thus moved over the said bath. In the case of good solderability of the lead (tin) layer the liquid lead-tin will creep upwards into the holes of the panel as a result of surface tension. After removing the panel from the lead-tin bath it is inspected to determine what fraction of the holes is filled entirely with lead-tin. If all the holes are filled entirely, the solderability is very good. The result of the measurement is that all the holes of the panel are filled entirely.

Claims

1. A lead immersion bath for the superficial exchange of a tin layer from a lead layer, which bath comprises an alkaline solution of a lead (II) compound and a complexing agent with which lead ions can form a soluble lead complex, characterized in that the complexing agent is chosen to be so that the complex constant of the lead complex in the solution used is smaller than the dissociation constant of hydroxyplumbite ions.

2. A lead immersion bath as claimed in Claim 1, characterized in that the complexing agent has been chosen from the group formed by ethylene diamine tetracetic acid, ethylene diamine tetramethyl phosphonic acid, diethylene triamine pentacetic acid, and alkali metal salts of the said acids.

3. A lead immersion bath as claimed in Claim 1, characterized in that the bath comprises an aqueous solution of 0.001 to 0.1 mol/l of lead (II) acetate, as well as alkali metal hydroxide and ethylene diamine tetracetic acid tetrasodium salt as a complexing agent.

4. A lead immersion bath as claimed in any one of Claims 1 to 3, characterized in that in addition 0.001 to 0.1 mol/l of tin (II) chloride has been added to the bath.

5. A method of superficially exchanging a tin layer for a lead layer while using a lead immersion bath as claimed in any of the Claims 1 to 4, characterized in that the exchanged layer is subjected to a thermal treatment between 183°C and 232°C while forming a top layer of a lead-tin alloy.

6. A method as claimed in Claim 5, characterized in that prior to the thermal treatment the exchanged layer is treated with a flux.

7. A printed circuit board having metallized holes comprising a top layer of a lead-tin alloy obtained by using the method as claimed in Claim 5 or 6.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| A | US-A-3 050 410 (GREENE) ----- | | C 23 C 18/46 |

TECHNICAL FIELDS
SEARCHED (Int. Cl.4)

C 23 C

The present search report has been drawn up for all claims

| Place of search | Date of completion of the search | Examiner |
|---|---|---|
| THE HAGUE | 05-04-1988 | NGUYEN THE NGHIEP |